(19) Europäisches Patentamt / European Patent Office / Office européen des brevets

(11) **EP 4 667 522 A1**

(12) **EUROPEAN PATENT APPLICATION**

(43) Date of publication:
**24.12.2025 Bulletin 2025/52**

(21) Application number: **25183129.3**

(22) Date of filing: **16.06.2025**

(51) International Patent Classification (IPC):
***C08K 5/13*** *(2006.01)* ***C09J 163/00*** *(2006.01)*
***H01L 23/00*** *(2006.01)*

(52) Cooperative Patent Classification (CPC):
(C-Sets available)
**C09J 163/00; C08K 5/13; C08L 61/14; H01L 23/00**
(Cont.)

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH LA MA MD TN**

(30) Priority: **21.06.2024 JP 2024100059**

(71) Applicant: **SHIN-ETSU CHEMICAL CO., LTD.**
**Tokyo 1000005 (JP)**

(72) Inventors:
- **KUSHIHARA, Naoyuki**
**Gunma, 379-0224 (JP)**
- **SUMITA, Kazuaki**
**Gunma, 379-0224 (JP)**

(74) Representative: **Ipsilon**
**12 Avenue d'Italie**
**75013 Paris (FR)**

# (54) EPOXY RESIN COMPOSITION

(57) One of the objects of the present disclosure is to provide an epoxy resin composition that has a low viscosity and provides a cured product having a low elasticity and a suppressed reduction of the tensile elasticity and adhesive strength even when stored at high temperatures. The present disclosure provides an epoxy resin composition, comprising (A) an epoxy resin other than the following component (B), (B) a polyoxyalkylene-containing epoxy resin having two epoxy groups per molecule, (C) a phenolic resin that is in a form of liquid at 25°C and has, per molecule, at least one functional group having an unsaturated double bond, and (D) an antioxidant.

EP 4 667 522 A1

(52) Cooperative Patent Classification (CPC): (Cont.)

C-Sets
**C08K 5/005, C08L 63/04;**
**C08K 5/005, C08L 71/02;**
**C08L 61/14, C08K 5/005;**
**C08L 63/00, C08L 71/02, C08L 61/14;**
**C08L 63/04, C08L 71/02, C08L 61/14;**
**C09J 163/00, C08L 71/02, C08K 5/13,**
**C08K 5/005;**
**C09J 163/00, C08L 71/02, C08L 61/14;**
**C09J 163/00, C08L 71/02, C08L 61/14,**
**C08K 5/005**

## Description

The present disclosure relates to an epoxy resin composition. More specifically, the present disclosure relates to an epoxy resin composition comprising a liquid phenolic resin.

Epoxy resin compositions have excellent adhesive strength as well as excellent heat resistance and electrical characteristics, and are thus used as sealing materials or adhesives in the fields of electrical or electronic equipment parts and automobile parts.

Epoxy resin compositions generally comprise curing agents that react with epoxy groups. Examples of curing agents include amine-based curing agents, phenol-based curing agents, acid anhydride-based curing agents, and thiol-based curing agents. Among these, phenol-based curing agents are used in the fields of power semiconductors due to their excellent heat resistance reliability and moisture resistance reliability (Patent Literature 1).

A solid phenol-based curing agent to which an allyl group or an alkyl group is introduced can be used as a liquid phenolic resin. A cured product obtained from an epoxy resin and a liquid phenolic resin is used for electronic material applications, such as underfill materials and adhesives, due to their excellent moisture resistance reliability (Patent Literatures 2 and 3).

As electronic parts have become smaller in recent years, there is a need for epoxy resins with lower elastic moduli to relax stress on electronic parts. To improve the impact resistance, the addition of polymeric thermoplastic resins is being considered (Patent Literature 4).

## PRIOR LITERATURES

### PATENT LITERATURES

Patent Literature 1: Japanese Patent Application Laid-Open No. 2021-063145
Patent Literature 2: Japanese Patent Application Laid-Open No. 2010-241877
Patent Literature 3: Japanese Patent Application Laid-Open No. 2016-037529
Patent Literature 4: Japanese Patent Application Laid-Open No. 2023-121887

## SUMMARY

However, the addition of a polymeric thermoplastic resin causes the problems of an increase of the viscosity and a reduction of the workability, which remain unsolved. Therefore, one of the objects of the present disclosure is to provide an epoxy resin composition that has a low viscosity and provides a cured product having a low elasticity and a suppressed reduction of the tensile elasticity and adhesive strength even when stored at high temperatures.

As a result of diligent research to solve the aforesaid problems, the present inventors have found that an epoxy resin composition comprising a liquid phenolic resin having an unsaturated double bond, such as an allyl group, together with a bi-functional epoxy resin having a polyoxyalkylene skeleton, provides a resin composition with a low viscosity, as well as a cured product with a low elasticity. The present inventors also found that an epoxy resin composition comprising an antioxidant together with the aforesaid liquid phenolic resin provides a cured product having a suppressed reduction of the tensile elasticity and adhesive strength when the cured product is stored at high temperatures, thereby completing the present disclosure.

Specifically, the present disclosure provides the following epoxy resin composition:

[1] An epoxy resin composition, comprising (A) an epoxy resin other than the following component (B), (B) a polyoxyalkylene-containing epoxy resin having two epoxy groups per molecule, (C) a phenolic resin having, per molecule, at least one functional group having an unsaturated double bond, in a form of liquid at 25°C, , and (D) an antioxidant.

The present disclosure also provides the following epoxy resin compositions:

[2] The epoxy resin composition according to the aforesaid [1], wherein the component (A) is an epoxy resin having one or more aromatic rings per molecule.
[3] The epoxy resin composition according to the aforesaid [1] or [2], wherein the component (A) is at least one resin selected from a bisphenol A-type epoxy resin, a bisphenol F-type epoxy resin, a naphthalene-type epoxy resin, and an aminophenol-type epoxy resin.
[4] The epoxy resin composition according to any one of the aforesaid [1] to [3], wherein the component (B) has an

epoxy equivalent of 170 g/eq. or more and 500 g/eq or less.

[5] The epoxy resin composition according to any one of the aforesaid [1] to [4], wherein an amount of the component (B) is 10 parts by mass or more and 500 parts by mass or less, relative to 100 parts by mass of the epoxy resin (A).

[6] The epoxy resin composition according to any one of the aforesaid [1] to [5], wherein the at least one functional group having the unsaturated double bond in the component (C) is, independently of each other, an alkenyl group having 2 to 6 carbon atoms.

[7] The epoxy resin composition according to any one of the aforesaid [1] to [6], wherein the component (C) is represented by the following formula (1):

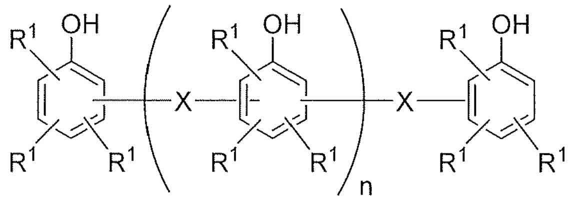

(1)

wherein $R^1$ is, independently of each other, a hydrogen atom or a group selected from a hydroxy group, an alkenyl group having 2 to 6 carbon atoms, an alkyl group having 1 to 6 carbon atoms, an aryl group having 6 to 12 carbon atoms, and an aralkyl group having 7 to 12 carbon atoms; one or more $R^1$ is an alkenyl group having 2 to 6 carbon atoms; n is a number of 0 to 10; and X is a divalent linking group selected from the group consisting of the following formulas:

$-CH_2-$ 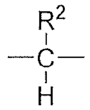 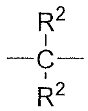 $-O-$ $-S-$ $-SO_2$

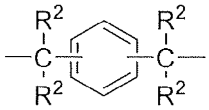 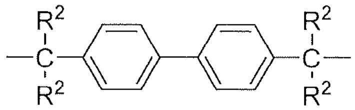 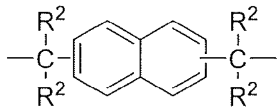

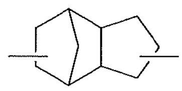

wherein $R^2$ is, independently of each other, a hydrogen atom or a methyl group.

[8] The epoxy resin composition according to any one of the aforesaid [1] to [7], wherein an amount of the component (D) is 0.01 to 20 parts by mass, relative to 100 parts by mass of the component (A).

[9] The epoxy resin composition according to any one of the aforesaid [1] to [8], wherein a mole equivalent ratio of the phenolic hydroxy groups in the component (C) is 0.1 to 2.0, per molar equivalent of a total of the epoxy groups in the component (A) and the component (B).

[10] The epoxy resin composition according to any one of the aforesaid [1] to [9], wherein the component (D) is at least one antioxidant selected from a phenol-based antioxidant, a sulfur-based antioxidant, and a phosphorus-based antioxidant.

[11] The epoxy resin composition according to any one of the aforesaid [1] to [10], wherein the epoxy resin composition has a viscosity, at 25°C, of 0.01 to 850 Pa·s.

[12] An adhesive comprising the epoxy resin composition according to any one of the aforesaid [1] to [11].

[13] An underfill agent comprising the epoxy resin composition according to any one of the aforesaid [1] to [11].

[14] A semiconductor device comprising a cured product of the epoxy resin composition according to any one of the aforesaid [1] to [11].

An epoxy resin composition of the present disclosure has a low viscosity, and a cured product of the epoxy resin composition has a low elasticity. Furthermore, the epoxy resin composition of the present disclosure provides a cured product that has a suppressed reduction of the tensile elasticity and adhesive strength even when stored at high temperatures.

## DETAILED DESCRIPTION

The following describes the present disclosure in detail.

The epoxy resin composition of the present disclosure comprises (A) an epoxy resin other than the following component (B), (B) a polyoxyalkylene-containing epoxy resin having two epoxy groups per molecule, (C) a phenolic resin that is in a form of liquid at 25°C and has, per molecule, at least one functional group having an unsaturated double bond, and (D) an antioxidant.

[(A) Epoxy resin]

The component (A) is an epoxy resin other than the following component (B). The epoxy resin is a major component of the present disclosure. The epoxy resin is a low molecular-weight pre-polymer having two or more epoxy groups per molecule, and is preferably a pre-polymer having a molecular weight of 300 to 8,000, more preferably a pre-polymer having a molecular weight of 350 to 4,000, and is a polymer formed by a ring-opening reaction of the epoxy groups of the pre-polymer. The epoxy resin (A) of the present embodiments may be appropriately selected from publicly known epoxy resins, and it is sufficient for the epoxy resin (A) to be an epoxy resin other than the component (B) below.

Examples of such epoxy resins include bisphenol-type epoxy resins, such as bisphenol A-type epoxy resin, bisphenol F-type epoxy resin, and bisphenol S-type epoxy resin; novolac-type epoxy resins, such as phenol novolac-type epoxy resin, cresol novolac-type epoxy resin, bisphenol A novolac-type epoxy resin, and bisphenol F novolac-type epoxy resin; alicyclic epoxy resins, such as dicyclopentadiene-type epoxy resin and 3,4-epoxycyclohexenylmethyl-3',4'-epoxycyclohexene carboxylate; polyfunctional phenol-type epoxy resins, such as resorcinol-type epoxy resin and resorcinol novolac-type epoxy resin; aminophenol-type epoxy resin, stilbene-type epoxy resin, triazine skeleton-containing epoxy resin, fluorene skeleton-containing epoxy resin, triphenolalkane-type epoxy resin, biphenyl-type epoxy resin, xylylene-type epoxy resin, biphenyl aralkyl-type epoxy resin, naphthalene-type epoxy resin, diglycidyl ether compounds of polycyclic aromatics such as anthracene, silicone-modified epoxy resin, phosphorus-containing epoxy resins obtained by introducing phosphorus compounds into these resins, and the like.

These may be used singly or in combination of two or more.

The component (A) is preferably an epoxy resin that is in a form of liquid at room temperature (25°C). Typically, the epoxy resin has a viscosity, at 25°C, of 0.6 to 100 Pa·s, or preferably 0.8 to 50 Pa·s. The epoxy equivalent of the component (A) is preferably 150 to 300, or more preferably 160 to 280. The component (A) in the epoxy resin preferably has one or more aromatic rings per molecule. By using said epoxy resin having one or more aromatic rings per molecule, preferred heat resistance reliability and moisture resistance reliability may be ensured. Such an epoxy resin is particularly preferably at least one resin selected from a bisphenol A-type epoxy resin, a bisphenol F-type epoxy resin, a naphthalene-type epoxy resin, and an aminophenol-type epoxy resin. As mentioned above, these resins may be used singly or in combination of two or more.

[(B) Polyoxyalkylene-containing epoxy resin having two epoxy groups per molecule]

The component (B) of the present disclosure is an epoxy resin that has two epoxy groups per molecule, and has a polyoxyalkylene skeleton. The aforesaid epoxy resin is added for the purpose of reducing the elastic modulus of cured products. The component (B) is a low molecular-weight pre-polymer having two epoxy groups per molecule, and is preferably a pre-polymer having a molecular weight of 300 to 8,000, or more preferably a pre-polymer having a molecular weight of 500 to 4,000.

Examples of the polyoxyalkylene skeleton include a polyethylene glycol skeleton and a polypropylene glycol skeleton. It is sufficient for the component (B) of the present embodimentsto have the polyoxyalkylene skeleton in the molecule, and the component (B) may be selected from any generally known polyoxyalkylene-containing bi-functional epoxy resin. Such examples include a polyoxyethylene-type epoxy resin such as polyethylene glycol diglycidyl ether; and a polyoxypropylene-type epoxy resin such as polypropylene glycol diglycidyl ether.

These resins may be used singly or in combination of two or more. The polyoxyalkylene-containing bi-functional epoxy resin is preferably in liquid form at room temperature (25°C). The polyoxyalkylene-containing bi-functional epoxy resin has a viscosity, at 25°C, of preferably 0.01 Pa·s to 100 Pa·s, more preferably 0.05 Pa·s to 75 Pa·s, or even more preferably 0.1 Pa·s to 50 Pa·s.

The aforesaid polyoxyalkylene-containing bi-functional epoxy resin is more preferably represented by the following structure:

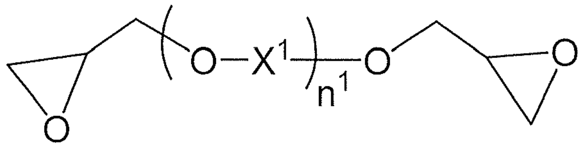

wherein $X^1$ is an alkylene having 2 to 12 carbon atoms, or preferably an alkylene having 2 to 6 carbon atoms. Examples of $X^1$ include ethylene, propylene, and the like, or more preferably ethylene or propylene. $n^1$ is 1 to 22, more preferably 2 to 18, or even more preferably 4 to 14. The alkylene may be branched.

The component (B) of the present disclosure preferably has an epoxy equivalent of 170 g/eq. or more and 500 g/eq or less. The lower limit of the epoxy equivalent is more preferably 185 g/eq. or more, or even more preferably 210 g/eq. or more. The upper limit of the epoxy equivalent is more preferably 475 g/eq. or less, or even more preferably 450 g/eq. or less. If the epoxy equivalent is less than the aforesaid lower limit, the elastic modulus of the cured product may not be sufficiently reduced. If the epoxy equivalent exceeds the aforesaid upper limit, unreacted epoxy groups may remain, which may cause a greater elastic modulus change during high-temperature storage.

The amount of the component (B) is preferably 10 parts by mass or more and 500 parts by mass or less, relative to 100 parts by mass of the aforesaid component (A). The upper limit is more preferably 450 parts by mass or less, or even more preferably 400 parts by mass or less. The lower limit is more preferably 25 parts by mass or more, even more preferably 40 parts by mass or more, or even more preferably 50 parts by mass or more. If the amount of the component (B) is less than the aforesaid lower limit, the elastic modulus of the cured product may not be sufficiently reduced. If the amount of the component (B) exceeds the aforesaid upper limit, unreacted epoxy groups may remain, which may cause a greater elastic modulus change during high-temperature storage.

[(C) Liquid phenolic resin]

The component (C) is a phenolic resin that is in liquid form at 25°C, and is a curing agent for the aforesaid epoxy resins. The component (C) is added to react with the epoxy groups in the aforesaid component (A) and the aforesaid component (B).

The liquid phenolic resin (C) is in liquid form at 25°C. The liquid phenolic resin has a viscosity, at 25°C, of preferably 0.1 Pa·s to 500 Pa·s, or more preferably 1 Pa·s to 50 Pa·s. Within these ranges, dispersion in the epoxy resin is easier. The viscosities of the phenolic resins and epoxy resins of the present disclosure are values determined by the method using a cone-plate rotational viscometer described in the Japanese Industrial Standards (JIS) Z8803:2011.

The liquid phenolic resin (C) of the present disclosure has, per molecule, at least one functional group having an unsaturated double bond. Examples of the functional group having the unsaturated double bond include an alkenyl group having 2 to 6 carbon atoms, and preferably an allyl group or a vinyl group.

It is sufficient for the liquid phenolic resin to have the aforesaid functional group having the unsaturated double bond, and the liquid phenolic resin may be selected from any generally known liquid phenolic resin. The liquid phenolic resin is more preferably represented by, for example, the following formula (1):

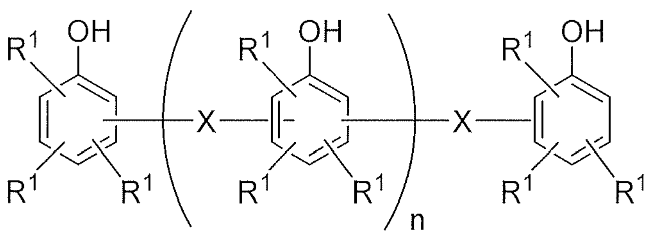

(1)

wherein $R^1$ is, independently of each other, a hydrogen atom, or a group selected from a hydroxy group, an alkenyl group having 2 to 6 carbon atoms, an alkyl group having 1 to 6 carbon atoms, an aryl group having 6 to 12 carbon atoms, and an aralkyl group having 7 to 12 carbon atoms; and one or more $R^1$ is an alkenyl group having 2 to 6 carbon atoms, or more preferably an allyl group or a vinyl group. n is a number of 0 to 10, preferably a number of 0 to 5, or more preferably a number of 1 to 5. X is a divalent linking group selected from the group consisting of the following formulas:

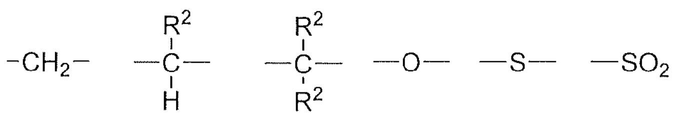

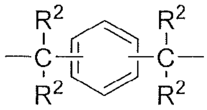 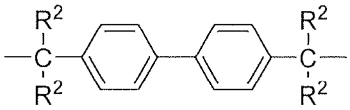 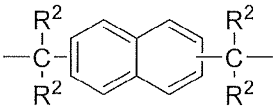

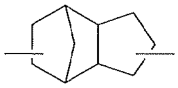

wherein $R^2$ is, independently of each other, a hydrogen atom or a methyl group.

In formula (1), $R^1$ is a hydrogen atom, or a group selected from: a hydroxy group; an alkenyl group having 2 to 6 carbon atoms such as an allyl group and a vinyl group; an alkyl group having 1 to 6 carbon atoms such as a methyl group, an ethyl group, an n-propyl group, an isopropyl group, an n-butyl group, an isobutyl group, a tert-butyl group, a pentyl group, a neopentyl group, a hexyl group, and a cyclohexyl group; an aryl group having 6 to 12 carbon atoms such as a phenyl group and a tolyl group; and an aralkyl group having 7 to 12 carbon atoms such as a benzyl group and a phenylethyl group.

The liquid phenolic resin represented by the aforesaid formula (1) is preferably an allyl group-containing phenolic resin such as a bisphenol A-type allyl phenolic resin, a bisphenol F-type allyl phenolic resin, a novolac-type allyl phenolic resin, an aralkyl-type allyl phenolic resin, and a resorcinol-type allyl phenolic resin. By using said allyl group-containing phenolic resin such as a bisphenol A-type allyl phenolic resin, a bisphenol F-type allyl phenolic resin, a novolac-type allyl phenolic resin, an aralkyl-type allyl phenolic resin, and a resorcinol-type allyl phenolic resin, a preferred viscosity and adhesive strength may be ensured. These resins may be used singly or in combination of two or more.

The amount of the liquid phenolic resin (C) is set so that the mole equivalent ratio of the phenolic hydroxy groups in the component (C), per molar equivalent of the total of the epoxy groups in the aforesaid component (A) and the aforesaid component (B), is preferably 0.1 to 2.0, more preferably 0.2 to 1.8, or even more preferably 0.4 to 1.5. If the molar equivalent ratio is less than 0.1, unreacted epoxy groups remain, which may reduce adhesion of the cured product. If the molar equivalent ratio exceeds 2.0, unreacted phenolic hydroxyl groups remain, which may cause strength deterioration of the cured product during high-temperature storage.

[(D) Antioxidant]

The antioxidant (D) is added to prevent oxidative deterioration of the cured product of the epoxy resin composition when stored at high temperatures. By combining the antioxidant with the liquid phenolic resin (C) mentioned above, the antioxidant may suppress reactions between the unsaturated double bonds in the component (C) even when stored at high temperatures. The antioxidant is thereby effective in suppressing the reduction of the bending strength and adhesive strength over time.

The aforesaid component (D) may be any generally known antioxidant. Among such antioxidants, one or more antioxidant selected from a phenol-based antioxidant, a sulfur-based antioxidant, and a phosphorus-based antioxidant are preferred, and a phenol-based antioxidant is particularly preferred. The melting point of the phenol-based antioxidant is preferably 80 to 250°C, more preferably 90 to 240°C, or particularly preferably 100 to 220°C.

Examples of the phenol-based antioxidant include n-octadecyl-3-(3,5-di-*t*-butyl-4-hydroxyphenyl)propionate, n-octadecyl-3-(3,5-di-*t*-butyl-4-hydroxyphenyl)acetate, neododecyl-3-(3,5-di-t-butyl-4-hydroxyphenyl)propionate, dodecyl-2-(3,5-dit-butyl-4-hydroxyphenyl)propionate, ethyl-3-(3,5-di-t-butyl-4-hydroxyphenyl)isobutyrate, octadecyl-3-(3,5-di-t-butyl-4-hydroxyphenyl)isobutyrate, 2-(n-octylthio)ethyl-3,5-di-t-butyl-4-hydroxyphenylacetate, 2-(n-octadecylthio) ethyl-3,5-di-t-butyl-4-hydroxyphenylacetate, 2-(n-octadecylthio)ethyl-3-(3,5-di-t-butyl-4-hydroxyphenyl)propionate, 2-(2-stearoyloxyethylthio)ethyl-7-(3-methyl-5-*t*-butyl-4-hydroxyphenyl)heptanoate, 2-hydroxyethyl-3-(3-methyl-5-t-butyl-4-hydroxyphenyl)propionate, pentaerythritol tetrakis[3-(3,5-dit-butyl-4-hydroxyphenyl)propionate], 3-(3,5-di-tert-butyl-4-hydroxyphenyl)stearyl propionate, 1,3,5-tris[[3,5-bis(1,1-dimethylethyl)-4-hydroxyphenyl]methyl]-1,3,5-triazine-2,4,6(1H,3H,5H)-trione, 1,1,3-tris(2-methyl-4-hydroxy-5-tert-butylphenyl)butane, 4,4'-butylidene bis(6-tert-butyl-m-cresol), pentaerythritol tetrakis[3-(3,5-di-tert-butyl-4-hydroxyphenyl)propionate], and 2,2'-dimethyl-2,2'-(2,4,8,10-tetraoxaspiro[5.5]undecane-3,9-diyl)dipropane-1,1'-diyl bis[3-(3-tert-butyl-4-hydroxy-5-methylphenyl)propanoate].

Examples of the sulfur-based antioxidant include dilauryl-3,3'-thiodipropionate, dimyristyl-3,3'-thiodipropionate, distearyl-3,3'-thiodipropionate, ditridecyl-3,3'-thiodipropionate, pentaerythrityl tetrakis(3-laurylthiopropionate), and bis [3-(dodecylthio)propionic acid]2,2-bis[[3-(dodecylthio)-1-oxopropyloxy]methyl]-1,3-propanediyl.

Examples of the phosphorus-based antioxidant include tridecyl phosphite, triphenylphosphite, tris(2,4-di-t-butylphenyl)phosphite, 2-ethylhexyl diphenyl phosphite, diphenyl tridecyl phosphite, 2,2-methylenebis(4,6-di-t-butylphenyl)octyl phosphite, distearyl pentaerythritol diphosphite, bis(2,6-di-t-butyl-4-methylphenyl)pentaerythritol diphosphite, 2-[[2,4,8,10-tetrakis(1,1-dimethylethyl)dibenzo[d,f][1,3,2]dioxaphosphepin-6-yl]oxy]-N,N-bis[2-[[2,4,8,10-tetrakis(1,1-dimethylethyl)dibenzo[d,f][1,3,2]dioxaphosphepin-6-yl]oxy]-ethyl]ethanamine, and 3,9-bis(octadecyloxy)-2,4,8,10-tetraoxa-3,9-diphosphaspiro[5.5]undecane.

The aforesaid antioxidant may be used singly or in combination of two or more.

The amount of the component (D) in the epoxy resin composition of the present disclosure, relative to 100 parts by mass of the aforesaid component (A), is preferably 0.01 to 20 parts by mass, more preferably 0.05 to 17.5 parts by mass, or even more preferably 0.1 to 15 parts by mass. If the amount of the component (D) is less than the aforesaid lower limit, the strength of the resin may be reduced by oxidative deterioration. If the amount of the component (D) exceeds the aforesaid upper limit, the resin strength may be reduced.

[Other additives]

In addition to the aforesaid components (A) to (D), other additives may be added, if necessary, to the epoxy resin composition of the present disclosure as long as the object and effects of the present invention are not impaired. Examples of the additives include (E) curing accelerators, (F) inorganic fillers, as well as flame retardants, ion-trapping agents, adhesion-imparting agents, stress-reducing agents, and colorants.

[(E) Curing accelerator]

As an optional component of the present disclosure, it is sufficient for the curing accelerator (E) to promote curing reactions of the aforesaid component (A), the aforesaid component (B), and the aforesaid component (C). The curing accelerator may be any generally known curing accelerator such as an imidazole-based curing accelerator, an organic phosphorus-based curing accelerator, and a tertiary amine-based curing accelerator.

Examples of the imidazole-based curing accelerator include 2-methylimidazole, 2-ethylimidazole, 2-undecylimidazole, 2,4-dimethylimidazole, 2-heptadecylimidazole, 1,2-dimethylimidazole, 1,2-diethylimidazole, 2-phenyl-4-methylimidazole, 2,4,5-triphenylimidazole, 2-ethyl-4-methylimidazole, 2-phenylimidazole, 1-benzyl-2-phenylimidazole, 1-cyanoethyl-2-methylimidazole, 1-cyanoethyl-2-undecylimidazole, 1-benzyl-2-methylimidazole, 2-phenyl-4,5-dihydroxymethylimidazole, 2-allyl-4,5-diphenylimidazole, and 2-phenyl-4-methyl-5-hydroxymethylimidazole.

Examples of the organic phosphorus-based curing accelerator include phosphines such as triphenylphosphine, tributylphosphine, tri(*p*-methylphenyl)phosphine, and tri(nonylphenyl)phosphine; phosphine-borane complexes such as triphenylphosphine-triphenylborane; phosphonium borate salts such as tetraphenylphosphonium tetraphenylborate, tetraphenylphosphonium tetra-p-tolylborate, p-tolyltriphenylphosphonium tetra-p-tolylborate, and tri-tert-butylphosphonium tetraphenylborate; and bis(tetrabutylphosphonium)dihydrodiene pyromelitate.

Examples of the tertiary amine-based curing accelerator include tertiary amine compounds such as triethylamine, benzyldimethylamine, α-methylbenzyldimethylamine, and 1,8-diazabicyclo[5.4.0]undecene-7; and salts of tertiary amine compounds such as 1,8-diazabicyclo[5.4.0]undecene-7. These tertiary amine-based curing accelerators may be used singly or in combination of two or more.

The amount of the curing accelerator (E), relative to 100 parts by mass of the aforesaid component (A), is preferably 0.01 to 20 parts by mass, or more preferably 0.5 to 10 parts by mass.

[(F) Inorganic filler]

An inorganic filler (F) is added to improve the resin strength and reduce the thermal expansion of the epoxy resin composition. Examples of the inorganic filler include silicas (such as fused silica, crystalline silica, and cristobalite), alumina, silicon nitride, aluminum nitride, boron nitride, titanium oxide, glass fibers, and magnesium oxide. The average particle size and shape of these inorganic fillers may be selected depending on the purpose.

In order to enhance the bond strength between the resin and the inorganic filler, the inorganic filler is preferably surface-treated in advance with a coupling agent, such as a silane coupling agent or a titanate coupling agent.

Examples of such a coupling agent include epoxy silanes such as γ-glycidoxypropyltrimethoxysilane, γ-glycidoxypropylmethyldiethoxysilane, and β-(3,4-epoxycyclohexyl)ethyltrimethoxysilane; aminosilanes such as N-β(aminoethyl)-γ-aminopropyltrimethoxysilane, reaction products of imidazole and γ-glycidoxypropyltrimethoxysilane, γ-aminopropyltriethoxysilane, and *N*-phenyl-γ-aminopropyltrimethoxysilane; and mercaptosilanes such as γ-mercaptosilane and γ-episulfidoxypropyltrimethoxysilane.

The amount of the coupling agent and a method of surface-treating in the surface treatment may follow a conventionally known method, and are not particularly limited in the present disclosure.

The amount of the inorganic filler, relative to 100 parts by mass of the aforesaid component (A), is preferably 10 to 20,000 parts by mass, or more preferably 30 to 10,000 parts by mass.

Flame retardant

A flame retardant is added for the purpose of imparting flame retardance. The flame retardant is not particularly limited and may be any known flame retardant. Examples of the flame retardant include phosphazene compounds, silicone compounds, zinc molybdate-supported talc, zinc molybdate-supported zinc oxide, aluminum hydroxide, magnesium hydroxide, and molybdenum oxide.

Ion-trapping agent

An ion-trapping agent is added for the purposes of capturing ionic impurities contained in the epoxy resin composition and preventing thermal deterioration and moisture absorption deterioration. The ion-trapping agent is not particularly limited, and may be any known ion-trapping agent. Examples of the ion-trapping agent include hydrotalcites, bismuth hydroxide compounds, and rare-earth oxides.

Adhesion-imparting agent

An adhesion-imparting agent is added for the purpose of imparting adhesion or stickiness (pressure-sensitive adhesion). The adhesion-imparting agent is not particularly limited, and examples include known adhesion-imparting agents such as urethane resins, phenolic resins, terpene resins, and silane coupling agents.

Among these, a silane coupling agent is preferred. Examples of the silane coupling agent include n-propyltrimethoxysilane, n-propyltriethoxysilane, n-octyltrimethoxysilane, n-octyltriethoxysilane, phenyltrimethoxysilane, phenyltriethoxysilane, methyltrimethoxysilane, methyltriethoxysilane, β-[methoxy(polyethyleneoxy)propyl]-trimethoxysilane, methoxytri(ethyleneoxy)propyltrimethoxysilane, γ-glycidyloxypropyltrimethoxysilane, γ-aminopropyltrimethoxysilane, γ-mercaptopropyltrimethoxysilane, γ-(methacryloyloxy)propyltrimethoxysilane, γ-isocyanatopropyltriethoxysilane, and γ-isocyanatopropyltrimethoxysilane.

The amounts of the additives other than the aforesaid components (E) and (F) vary depending on the purpose of the composition, but may be generally 5% by mass or less of the entire epoxy resin composition, excluding the inorganic filler (F).

The epoxy resin composition of the present disclosure is preferably liquid at room temperature (25°C). The epoxy resin composition has a viscosity, at 25°C, of preferably 0.1 to 850 Pa·s. In the present disclosure, the viscosity of the epoxy resin composition is a value determined at 25°C by the method using a cone-plate rotational viscometer described in JIS Z8803:2011.

The epoxy resin composition of the present disclosure may be prepared by a process shown below. For example, the components (A) to (D) are simultaneously or separately mixed, stirred, dissolved, and/or dispersed, optionally with heat treatment, to obtain a mixture of the components (A) to (D). Preferably, the liquid phenolic resin (C) is added to the mixture of the components (A), (B), and (D), followed by stirring, dissolution, and/or dispersion and, thereby, obtaining a mixture of the components (A) to (D). Depending on the purpose of use, other additives, such as at least one agent among a curing accelerator which is the component (E), an inorganic filler which is the component (F), a flame retardant, an ion-trapping agent, an adhesion-imparting agent, a stress-reducing agent, and a colorant may be added and mixed with the mixture of the components (A) to (D).

The device for the mixing, stirring, and dispersion is not particularly limited. For example, a milling machine equipped with a stirrer and a heater, a two-roll mill, a three-roll mill, a ball mill, a planetary mixer, or a masscolloider may be used, and these devices may be used in combination as appropriate.

The epoxy resin composition of the present disclosure may be used as a cured product after being cured. The curing conditions for the epoxy resin composition of the present disclosure are not particularly limited. For example, the epoxy resin composition may be heated at a temperature in the range of 60 to 200°C, or preferably 80 to 180°C for 30 minutes to 10 hours, or preferably 1 to 5 hours. The epoxy resin composition of the present disclosure may be cured at a low temperature and in a short period of time. Therefore, the epoxy resin composition may be sufficiently cured even at a temperature in the range of 70 to 130°C for about 10 minutes to 2 hours.

According to the present disclosure, there is provided a process for an epoxy resin composition containing, as essential components, the aforesaid component (B) and the aforesaid component (C), in which the process reduces the elastic modulus of a cured product of the epoxy resin composition. This process comprises the addition, as essential components, of the aforesaid component (A) and the aforesaid component (D) in addition to the aforesaid component (B) and the aforesaid component (C) of the epoxy resin composition, and suppresses a reduction of the tensile elasticity and adhesive strength of the epoxy resin composition during high-temperature storage.

The epoxy resin composition of the present disclosure has excellent adhesive strength and excellent heat resistance and, thus, may be used as a sealing material, an underfill material, or an adhesive in the fields of electrical or electronic equipment parts, and automobile parts. The epoxy resin composition of the present disclosure has excellent

heat resistance reliability and moisture resistance reliability and, thus, may be suitably used in the fields of power semiconductors and the like. Among these, the epoxy resin composition of the present disclosure is suitably used for a semiconductor device having a support, a semiconductor element placed on the support, and a cured product of the epoxy resin composition that seals the semiconductor element. Particularly, the epoxy resin composition is suitably used for a semiconductor device in which the epoxy resin composition fills the gap between the semiconductor element and the support.

## EXAMPLES

Some of the present embodiments will be explained below in further detail with reference to a series of Examples and Comparative Examples, but the present invention is in no way limited by these Examples.

In Table 1, the amounts indicate parts by mass. The "mole equivalent ratio" in Table 1 means the ratio of the total molar equivalent of the phenolic hydroxy groups (active hydrogens) in the component (C) to one molar equivalent of the total of the epoxy groups in the components (A) and (B).

The components used in the Examples and Comparative Examples are as described below.

(A) Epoxy resin

(A1) Mixed product of bisphenol A-type epoxy resin and bisphenol F-type epoxy resin (ZX1059, viscosity at 25°C: 2,000 mPa·s, epoxy equivalent: 166 g/eq., manufactured by Nippon Steel Chemical & Material Co., Ltd.).

(B) Polyoxyalkylene-containing epoxy resins having two epoxy groups per molecule

(B1) Polyethylene glycol diglycidyl ether (EX-821, viscosity at 25°C: 40 mPa·s, epoxy equivalent: 185 g/eq., manufactured by Nagase ChemteX Corporation; in the following formula, $X^1$ is ethylene, and $n^1 = 4$)

(B2) Polyethylene glycol diglycidyl ether (EX-830, viscosity at 25°C: 70 mPa·s, epoxy equivalent: 268 g/eq., manufactured by Nagase ChemteX Corporation; in the following formula, $X^1$ is ethylene, and $n^1 = 9$)

(B3) Polyethylene glycol diglycidyl ether (EX-841, viscosity at 25°C: 110 mPa·s, epoxy equivalent: 372 g/eq., manufactured by Nagase ChemteX Corporation; in the following formula, $X^1$ is ethylene, and $n^1 = 13$)

(B4) Polypropylene glycol diglycidyl ether (EX-931, viscosity at 25°C: 130 mPa·s, epoxy equivalent: 471 g/eq., manufactured by Nagase ChemteX Corporation; in the following formula, $X^1$ is methylethylene, and $n^1 = 11$)

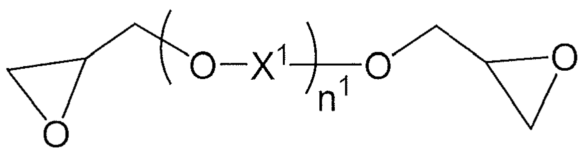

(C) Liquid phenolic resin

(C1) Novolac-type allyl phenolic resin of the following formula (MEH-8000H, viscosity at 25°C: 1,600 mPa·s, manufactured by UBE Corporation)

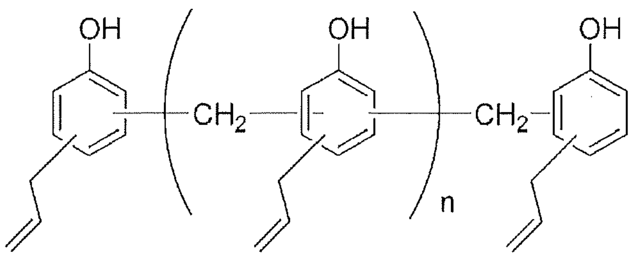

wherein n = 0 to 4.

(C2) 2,2'-Diallyl bisphenol A of the following formula (DABPA, viscosity at 25°C: 20,000 mPa·s, manufactured by Daiwa Kasei Industrial Co., Ltd.)

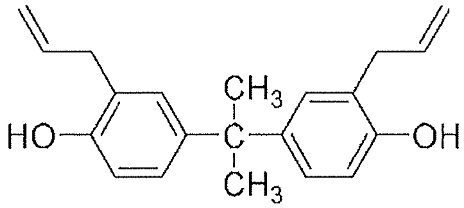

(C') Epoxy resin curing agent for Comparative Examples

(C'1) Bisphenol A (solid at 25°C, melting point: 158°C, manufactured by Tokyo Chemical Industry Co., Ltd.)

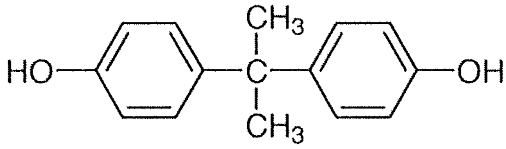

(D) Antioxidant

(D1) Hindered phenol-based antioxidant (AO-20, melting point: 220°C, manufactured by Adeka Corporation)

[Other additives as optional components]

(E) Curing accelerator

(E1) Imidazole-based curing accelerator (product name: 2P4MHZ-PW, manufactured by Shikoku Chemicals Corporation)

The components were mixed with a planetary mixer in the amounts shown in Examples 1 to 17 and Comparative Examples 1 to 4 to prepare epoxy resin compositions. The epoxy resin compositions thus obtained were evaluated as follows. The results are shown in Table 1.

[Viscosity]

The viscosity of each epoxy resin composition at 25°C was determined in accordance with JIS Z 8803:2011. Specifically, the viscosity of each sample after 2 minutes from setting was determined at a determination temperature of 25°C using a cone-plate rotational viscometer (E-type viscometer).

[Cured product tensile elasticity]

Each epoxy resin composition was poured into a mold and heated for 1 hour at 120°C and then for 3 hours at 180°C to prepare a test sample (a cured product) that was 100 mm long and 10 mm wide with a thickness of 4 mm. The tensile elasticity (MPa) was determined in accordance with JIS K 7161-1:2014 for each of the aforesaid test samples (cured products) using EZ TEST (EZ-L, manufactured by Shimadzu Corporation) with the conditions of a test speed of 500 mm/min, a clamp-to-clamp distance of 80 mm, and a distance between gauge marks of 40 mm.

[Tensile elasticity retention rate after high-temperature storage]

Each test sample (cured product) was made with the same conditions as the aforesaid [cured product tensile elasticity], stored for 150 hours in an oven set to 180°C, and then cooled to 25°C. The tensile elasticity (MPa) was determined in accordance with JIS K 7161-1:2014 for each of the aforesaid test samples (cured products) using EZ TEST (EZ-L, manufactured by Shimadzu Corporation) with the conditions of a test speed of 500 mm/min, a clamp-to-clamp distance of 80 mm, and a distance between gauge marks of 40 mm. More specifically, the tensile elasticity retention rate after high-temperature storage was calculated using the following formula:

Tensile elasticity after high-temperature storage = (tensile elasticity after storing for 150 hours at 180°C)/(tensile elasticity before storing)$\times$100 (%)

[Adhesive strength retention rate after high-temperature storage]

Each epoxy resin composition was applied to a copper frame having a size of 10 mm×10 mm so that the applied area was 4 $mm^2$, and a silicon chip was placed thereon, followed by heating for 1 hour at 120°C and then 3 hours at 180°C to produce a test piece. The shear adhesive strength at room temperature (25°C) of the test piece was determined by a bond tester, DAGE-Series-4000PXY (manufactured by DAGE), and the adhesive strength was evaluated. The test piece thus obtained was stored for 150 hours in an oven at 180°C, followed by cooling to 25°C, and then the shear adhesive strength was determined. More specifically, the adhesive strength retention rate after high-temperature storage was calculated using the following formula:

Adhesive strength retention rate = (shear adhesive strength after storing for 150 hours at 180°C)/(shear adhesive strength before storing)×100 (%)

[Table 1]

| | | | Example 1 | Example 2 | Example 3 | Example 4 | Example 5 | Example 6 | Example 7 | Example 8 |
|---|---|---|---|---|---|---|---|---|---|---|
| Composition (Parts by mass) | Component (C) /Components (A) and (B) [Mole equivalent ratio] | | 1.0 | 1.0 | 1.0 | 1.0 | 1.0 | 1.0 | 1.0 | 1.0 |
| | Epoxy resin (A1) | | 100 | 100 | 100 | 100 | 100 | 100 | 100 | 100 |
| | Polyoxyalkylene-containing epoxy resin (B1) | | 43.0 | | | | | | | |
| | Polyoxyalkylene-containing epoxy resin (B2) | | | 42.9 | | | | | | |
| | Polyoxyalkylene-containing epoxy resin (B3) | | | | 42.9 | | 11.0 | 100.0 | 399.0 | 100.0 |
| | Polyoxyalkylene-containing epoxy resin (B4) | | | | | 42.8 | | | | |
| | Liquid phenolic resin (C1) | | 117.7 | 107.5 | 101.2 | 97.6 | 89.0 | 122.9 | 236.0 | |
| | Liquid phenolic resin (C2) | | | | | | | | | 134.5 |
| | Bisphenol A (C'1) | | | | | | | | | |
| | Antioxidant (D1) | | 5.2 | 5.0 | 4.9 | 4.8 | 4.0 | 6.5 | 14.7 | 6.7 |
| | Curing accelerator (E1) | | 2.6 | 2.5 | 2.4 | 2.4 | 2.0 | 3.2 | 7.4 | 3.3 |
| Evaluation | Viscosity | Pa·s | 2.9 | 2.7 | 3.2 | 3.6 | 4.5 | 1.8 | 0.9 | 5 |
| | Tensile elasticity | MPa | 1200 | 1000 | 900 | 700 | 1400 | 200 | 80 | 450 |
| | Tensile elasticity change rate after high-temperature storage | % | 110 | 110 | 115 | 115 | 110 | 120 | 130 | 120 |
| | Adhesive strength retention rate after high-temperature storage | % | 91 | 92 | 90 | 90 | 93 | 86 | 87 | 91 |

[Table 2]

| | | | Comparative Example 1 | Comparative Example 2 | Comparative Example 3 | Comparative Example 4 |
|---|---|---|---|---|---|---|
| Composition (Parts by mass) | Component (C) /Components (A) and (B) [Mole equivalent ratio] | | 1.0 | - | 1.0 | 1.0 |
| | Epoxy resin (A1) | | 100 | 100 | 100 | 100 |
| | Polyoxyalkylene-containing epoxy resin (B1) | | | | 43.0 | 43.0 |
| | Polyoxyalkylene-containing epoxy resin (B2) | | | | | |
| | Polyoxyalkylene-containing epoxy resin (B3) | | | 42.9 | | |
| | Polyoxyalkylene-containing epoxy resin (B4) | | | | | |
| | Liquid phenolic resin (C1) | | 84.8 | | 117.7 | |
| | Liquid phenolic resin (C2) | | | | | |
| | Bisphenol A (C'1) | | | | | 81.8 |
| | Antioxidant (D1) | | 3.8 | 2.9 | | 4.5 |
| | Curing accelerator (E1) | | 1.9 | 1.4 | 2.6 | 2.3 |
| Evaluation | Viscosity | Pa·s | 5.5 | 1.1 | 2.9 | Undeterminable |
| | Tensile elasticity | MPa | 2100 | Curing defect | 1200 | 1800 |
| | Tensile elasticity change rate after high-temperature storage | % | 115 | Untestable | 210 | 190 |
| | Adhesive strength retention rate after high-temperature storage | % | 88 | Curing defect | 56 | 45 |

As shown in Table 2 above, the tensile elasticity of the cured product was high for an epoxy resin composition that did not contain the polyoxyalkylene-containing epoxy resin (B) (Comparative Example 1). Curing did not proceed for an epoxy resin composition that did not contain a curing agent (Comparative Example 2). For an epoxy resin composition that contained, instead of the liquid phenolic resin (C) of the present disclosure, bisphenol A without an unsaturated double bond-containing group and in solid form at room temperature, the epoxy resin composition had a high viscosity at 25°C, and resulted in a cured product having a high tensile elasticity change rate and a reduced adhesive strength retention rate after high-temperature storage (Comparative Example 4). A cured product obtained from an epoxy resin composition that contained the component (B) and the component (C) of the present disclosure but did not contain the antioxidant (D) had a high tensile elasticity change rate and a reduced adhesive strength retention rate after high-temperature storage (Comparative Example 3).

In contrast, as shown in Table 1 above, the epoxy resin composition of the present disclosure had a low viscosity, the cured product obtained from the epoxy resin composition had a low tensile elasticity, and the cured product had a suppressed reduction of the tensile elasticity change and adhesive strength retention rate when stored at a high temperature.

The epoxy resin composition of the present disclosure has a low viscosity, and a cured product of the epoxy resin composition has a low elasticity. Furthermore, the cured product that is provided has a suppressed reduction of the tensile elasticity and adhesive strength even when stored at high temperatures. The epoxy resin composition of the present disclosure may be suitably used as a sealing material, an underfill material, or an adhesive in the fields of electrical or electronic equipment parts, and automobile parts.

## Claims

1. An epoxy resin composition, comprising

   (A) an epoxy resin other than the following component (B),
   (B) a polyoxyalkylene-containing epoxy resin having two epoxy groups per molecule,
   (C) a phenolic resin having, per molecule, at least one functional group having an unsaturated double bond, in a form of liquid at 25 °C, and
   (D) an antioxidant.

2. The epoxy resin composition according to claim 1, wherein the component (A) is an epoxy resin having one or more aromatic rings per molecule.

3. The epoxy resin composition according to claim 1, wherein the component (A) is at least one resin selected from a

bisphenol A-type epoxy resin, a bisphenol F-type epoxy resin, a naphthalene-type epoxy resin, and an aminophenol-type epoxy resin.

**4.** The epoxy resin composition according to claim 1, wherein the component (B) has an epoxy equivalent of 170 g/eq. or more and 500 g/eq or less.

**5.** The epoxy resin composition according to claim 1, wherein an amount of the component (B) is 10 parts by mass or more and 500 parts by mass or less, relative to 100 parts by mass of the epoxy resin (A).

**6.** The epoxy resin composition according to claim 1, wherein the at least one functional group having the unsaturated double bond in the component (C) is, independently of each other, an alkenyl group having 2 to 6 carbon atoms.

**7.** The epoxy resin composition according to claim 1, wherein the component (C) is represented by the following formula (1):

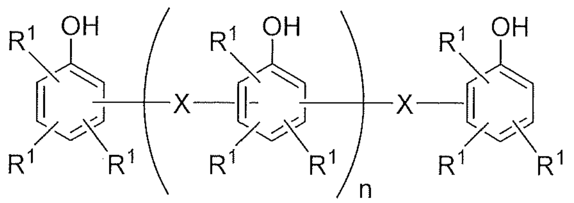

(1)

wherein $R^1$ is, independently of each other, a hydrogen atom or a group selected from a hydroxy group, an alkenyl group having 2 to 6 carbon atoms, an alkyl group having 1 to 6 carbon atoms, an aryl group having 6 to 12 carbon atoms, and an aralkyl group having 7 to 12 carbon atoms; one or more of $R^1$s is an alkenyl group having 2 to 6 carbon atoms; n is a number of 0 to 10; and X is a divalent linking group selected from the group consisting of the following formulas:

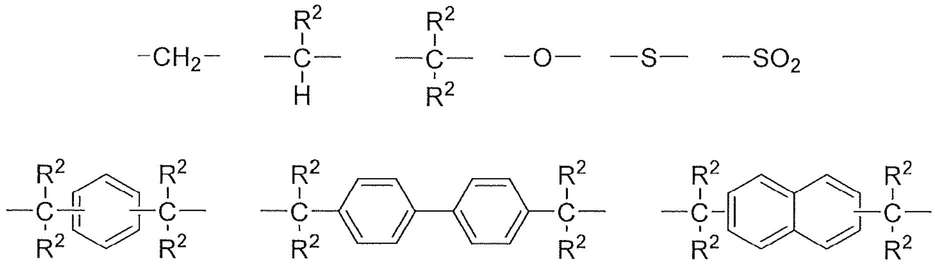

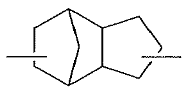

wherein $R^2$ is, independently of each other, a hydrogen atom or a methyl group.

**8.** The epoxy resin composition according to claim 1, wherein an amount of the component (D) is 0.01 to 20 parts by mass, relative to 100 parts by mass of the component (A).

**9.** The epoxy resin composition according to claim 1, wherein a mole equivalent ratio of the phenolic hydroxy groups in the component (C) is 0.1 to 2.0, per molar equivalent of a total of the epoxy groups in the component (A) and the component (B).

**10.** The epoxy resin composition according to claim 1, wherein the component (D) is at least one antioxidant selected from a phenol-based antioxidant, a sulfur-based antioxidant, and a phosphorus-based antioxidant.

**11.** The epoxy resin composition according to claim 1, wherein the epoxy resin composition has a viscosity, at 25 °C, of 0.01 to 850 Pa·s.

**12.** An adhesive comprising the epoxy resin composition according to any one of claims 1 to 11.

**13.** An underfill agent comprising the epoxy resin composition according to any one of claims 1 to 11.

**14.** A semiconductor device comprising a cured product of the epoxy resin composition according to any one of claims 1 to 11.

Europäisches Patentamt
European Patent Office
Office européen des brevets

# EUROPEAN SEARCH REPORT

Application Number
EP 25 18 3129

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | US 2016/040048 A1 (SUMITA KAZUAKI [JP]) 11 February 2016 (2016-02-11) * paragraph [[0058]]; examples 1-6 * * claims 1-9 * ----- | 1-14 | INV. C08K5/13 C09J163/00 H01L23/00 |
| A | US 10 253 223 B2 (LG CHEMICAL LTD [KR]) 9 April 2019 (2019-04-09) * examples 1-5 * * claims 1-20 * ----- | 1-14 | |

TECHNICAL FIELDS SEARCHED (IPC)

C08K
C09J
H01L

The present search report has been drawn up for all claims

1

| Place of search | Date of completion of the search | Examiner |
|---|---|---|
| The Hague | 7 November 2025 | Popescu, Teodora |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
.......................................................................
& : member of the same patent family, corresponding document

EPO FORM 1503 03.82 (P04C01)

# ANNEX TO THE EUROPEAN SEARCH REPORT ON EUROPEAN PATENT APPLICATION NO. EP 25 18 3129

This annex lists the patent family members relating to the patent documents cited in the above-mentioned European search report.
The members are as contained in the European Patent Office EDP file on
The European Patent Office is in no way liable for these particulars which are merely given for the purpose of information.

07-11-2025

| Patent document cited in search report | Publication date | Patent family member(s) | Publication date |
|---|---|---|---|
| US 2016040048 A1 | 11-02-2016 | JP 2016037529 A | 22-03-2016 |
| | | US 2016040048 A1 | 11-02-2016 |
| US 10253223 B2 | 09-04-2019 | CN 107924912 A | 17-04-2018 |
| | | JP 6651228 B2 | 19-02-2020 |
| | | JP 2019509620 A | 04-04-2019 |
| | | KR 20170113430 A | 12-10-2017 |
| | | TW 201802216 A | 16-01-2018 |
| | | US 2018237667 A1 | 23-08-2018 |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2021063145 A
- JP 2010241877 A
- JP 2016037529 A
- JP 2023121887 A